# EUROPEAN PATENT APPLICATION

(11) **EP 1 677 418 A1**
(43) Date of publication of application: **05.07.2006**
(21) Application number: 06100084.0
(22) Date of filing: 04.01.2006
(51) Int. Cl.: H03G 3/20, H04N 5/52, H04B 1/10, H03G 3/32

(54) **Signal amplifying apparatus and method**

(30) Priority: 04.01.2005 KR 2005000466
(71) Applicant: SAMSUNG ELECTRONICS CO., LTD., Suwon-si, Gyeonggi-do (KR)
(72) Inventor: Kim, Min-jyoung, Gyeonggi-do Suwon-si (KR)
(74) Representative: Waddington, Richard

(57) **Abstract**

A signal amplifying apparatus and method selectively amplify a received signal according to the strength of the received signal. The signal amplifying apparatus includes a signal receiving unit (120) for outputting a state signal according to a state of a received radio frequency (RF) signal, an amplifying unit (130) for amplifying the received RF signal and a control unit (140) for determining whether to operate the amplifying unit (130) according to the output state signal.

## Description

Apparatuses and methods consistent with the present invention relate to signal amplification, and more particularly, to selectively amplifying a received signal according to the strength of the received signal.

Generally, a television receiver is provided with a low noise amplifier (LNA) installed between an antenna and a tuner in order to heighten the receiving sensitivity. This LNA has a superior noise filtering characteristic.

The strength of a radio frequency (RF) signal received through an antenna changes according to the area and environment. For example, when an RF signal is received by a television receiver, the strength of the received RF signal is weaker than the original signals due to the influence of neighboring buildings, changes in the air, and other environmental conditions, and the signal is affected by an interference signal.

This interference signal is called a beat, and as the strength of the received RF signal becomes weaker, the RF signal becomes more susceptible to the influence of the beat. Accordingly, picture interference occurs due to the influence of the beat, and it becomes difficult to obtain a clear picture.

As described above, since the RF signal has a very low power level if the strength of the received RF signal is weak, an LNA having a gain of about 10 to 20 dB, in order to maintain the received RF signal at a specified power level, is installed at the front end of a tuner to amplify the received RF signal. If the strength of the received RF signal is strong, the RF signal bypasses the LNA without being amplified.

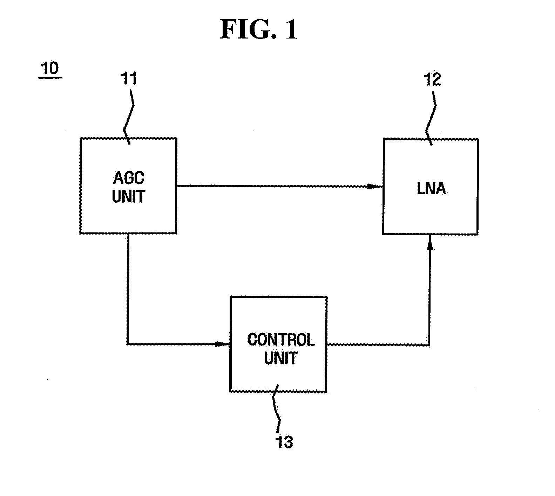

FIG. 1 illustrates the construction of a conventional signal amplifying apparatus.

As illustrated in FIG. 1, the conventional signal amplifying apparatus 10 includes an automatic gain control (AGC) unit 11 for outputting an AGC signal according to the strength of a received RF signal, an LNA 12 for amplifying the RF signal, and a control unit 13 for controlling the LNA 12 to selectively amplify the received RF signal according to an output AGC signal.

The control unit 13 compares the AGC signal output from the AGC unit 11 with a predetermined reference value and selectively operates the LNA 12 according to the result of the comparison. Specifically, if the output AGC signal is greater than the reference value, the control unit 13 decides that the received RF signal is weak and sets the LNA 12 in an "on" state. If the output AGC signal is less than the reference value, the control unit 13 decides that the received RF signal is strong and sets the LNA 12 in an "off" state, so that the RF signal bypasses the LNA 12 without being amplified.

In this case, the reference value used to determine whether to operate the LNA 12 is set during installation.

Accordingly, if the environment is changed, an accurate reference value cannot be guaranteed, and thus, the operational reliability of the LNA can decrease. In other words, since the reference value set in consideration of the environment (for example, type of area, presence of buildings, type of weather) is fixed during installation, the same reference value is used even if the environment is changed. Accordingly, a scheme for efficiently operating the LNA 12 by modifying the reference value if the environment is changed is required.

Korean Patent Unexamined Publication No. 1998-0039797 discloses a television receiving apparatus and a control method thereof which detects the level of an AGC signal, and sets the LNA in an "on" state if the AGC signal is less than a specified level, whereas it sets the LNA in an "off" state if the AGC signal is above the specified level. Although this apparatus and method sets the LNA in an "on/off" state according to the level of the AGC signal after setting the specified reference value, it does not provide any scheme for correcting the reference value according to changes in the environment.

The present invention provides a signal amplifying apparatus and method which can efficiently amplify a received signal by correcting a reference value according to the environment and determining whether to amplify the received signal according to the corrected reference value.

According to the present invention there is provided an apparatus and method as set forth in the appended claims. Preferred features of the invention will be apparent from the dependent claims, and the description which follows.

According to an aspect of the present invention, there is provided a signal amplifying apparatus which comprises a signal receiving unit for outputting a state signal according to a state of a received RF signal, an amplifying unit for amplifying the received RF signal and a control unit for determining whether to operate the amplifying unit according to the output state signal.

According to another aspect of the present invention, there is provided a signal amplifying method, which comprises the steps of outputting a state signal according to a state of a received RF signal, and determining whether to amplify the received RF signal according to the output state signal.

For a better understanding of the invention, and to show how embodiments of the same may be carried into effect, reference will now be made, by way of example, to the accompanying diagrammatic drawings in which:
FIG. 1 is a block diagram illustrating the construction of a conventional signal amplifying apparatus;
FIG. 2 is a block diagram illustrating a signal amplifying apparatus according to an exemplary embodiment of the present invention; and
FIG. 3 is a flowchart illustrating a signal amplifying method according to an exemplary embodiment of the present invention.

Hereinafter, exemplary embodiments of the present invention will be described in detail with reference to the accompanying drawings. The aspects and features of the present invention and methods for achieving the aspects and features will be apparent by referring to the exemplary embodiments to be described in detail with reference to the accompanying drawings. However, the present invention is not limited to the exemplary embodiments disclosed hereinafter, but will be implemented in diverse forms. The matters defined in the description, such as the detailed construction and elements, are nothing but specific details provided to assist those of ordinary skill in the art in a comprehensive understanding of the invention, and the present invention is only defined within the scope of the appended claims. In the entire description of the present invention, the same drawing reference numerals are used for the same elements across various figures.

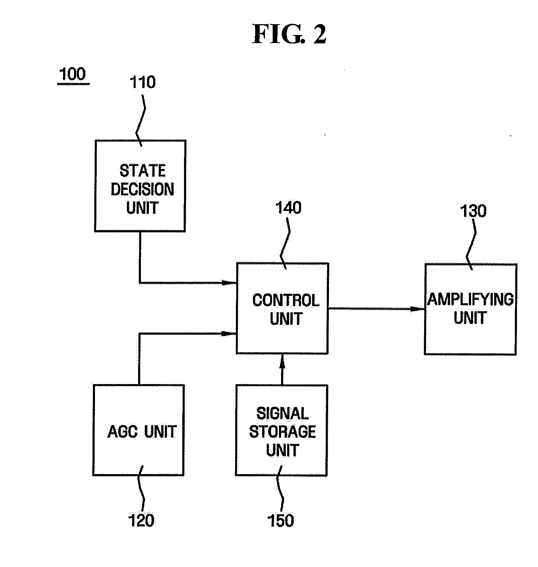

FIG. 2 is a block diagram illustrating a signal amplifying apparatus according to an exemplary embodiment of the present invention.

As illustrated in FIG. 2, the signal amplifying apparatus 100 according to an exemplary embodiment of the present invention includes a state decision unit 110 for deciding the state of an RF signal received through an antenna, an AGC unit 120 for outputting an AGC signal according to the strength of the received RF signal, and a control unit 140 for determining whether to operate an amplifying unit 130 that amplifies the received RF signal according to the output AGC signal and the output state signal.

In the exemplary embodiment of the present invention, although it is exemplified that the received RF signal is a broadcasting signal, the present invention is not limited thereto. Also, it is exemplified that the state decision unit 110 serves as a decoder for decoding the received broadcasting signal and outputting the state signal according to the state of the received broadcasting signal (for example, according to the signal-to-noise ratio). In this case, the state signal is output only when the received RF signal has deteriorated due to environment changes. Additionally, in the exemplary embodiment of the present invention, although it is exemplified that the amplifying unit 130 comprises an LNA, it may comprise another amplifier that is capable of performing the relevant operation.

The control unit 140 compares the output AGC signal with a specified reference value and determines whether to operate the amplifying unit 130 according to the result of the comparison. In other words, if the output AGC signal is greater than the reference value, the control unit 140 decides that the received RF signal is weak and sets the amplifying unit 130 in an "on" state. Otherwise, the control unit 140 decides that the received RF signal is strong and sets the amplifying unit 130 in an "off" state.

Further, the control unit 140 can reset the reference value according to the state signal output from the state decision unit 110. In other words, the control unit 140 uses the set reference value or the reference value set as a default before the state signal is output, and resets the reference value according to the output state signal. In the exemplary embodiment of the present invention, information about the reference value may be stored in the control unit 140 or in a separately provided memory (e.g., a flash memory). Accordingly, in the case where the power is turned off and then on again, the reference value can be referred to again by accessing the memory.

Additionally, the control unit 140 can decide whether to operate the amplifying unit 130 by comparing the previously used reference value (hereinafter, referred to as the "first reference value") with the reference value reset according to the state signal (hereinafter, referred to as the "second reference value"). If the state signal is output from the state decision unit 110, the control unit 140 first sets the second reference value based on data sampled by a signal storage unit 150. If the second reference value is less than the first reference value, the control unit 140 may not operate the amplifying unit 130 even though the received RF signal is weak. In this case, the control unit 140 sets the second reference value as the new first reference value to be hereinafter referred to, and operates the amplifying unit 130 accordingly. However, if the second reference value is greater than the first reference value, the control unit 140 decides that no reference value to be newly referred to exists, and it uses the existing first reference value. In this case, since the state signal is output from the state decision unit 110, the control unit 140 operates the amplifying unit 130 accordingly.

If a state signal is not output from the state decision unit 110, the control unit 140 can decide whether to operate the amplifying unit 130 using the first reference value and the output AGC signal in the same manner as the conventional apparatus. Meanwhile, the first reference value used in the exemplary embodiment of the present invention means the state signal stored just before the second reference value has been set on the basis of the presently output state signal. The reference values set according to the respective state signals are successively stored in a specified memory, and the last stored reference value is used as the first reference value.

In the exemplary embodiment of the present invention, the signal amplifying apparatus 100 may further include a signal storage unit 150 for sampling the AGC signal output from the AGC unit 120 at predetermined intervals and storing the sampled AGC signal. In this case, the signal storage unit 150 stores the successively sampled data, and a buffer (e.g., a ring buffer) that can process the last stored data as the newest data may be used. In this case, the signal storage unit 150 may also store the reference values according to the above-described state signals.

Additionally, the control unit 140 can store a highest-level AGC signal and a lowest-level AGC signal in the signal storage unit 150, among the AGC signals output from the AGC unit 120. The reason for the storing of the highest-level AGC signal and the lowest-level AGC signal is that an average-level AGC signal can be obtained through the highest-level AGC signal and the lowest-level AGC signal. In this case, the average-level AGC signal can be used together with the above-described state signal when setting the second reference value (as described above). Specifically, after the control unit sets the second reference value through the above-described state signal, it can correct the second reference value according to the average-level AGC signal so that it can set the second reference value more accurately.

Further, the highest-level AGC signal and the lowest-level AGC signal stored in the signal storage unit 150 can be updated whenever the sampling is performed.

The operation of the signal amplifying apparatus as constructed above according to an exemplary embodiment of the present invention is explained in detail in the following.

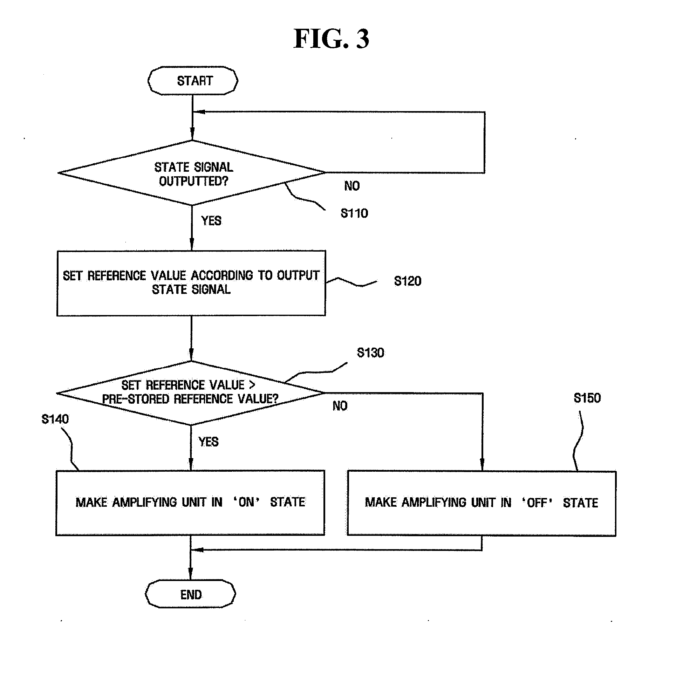

FIG. 3 is a flowchart illustrating a signal amplifying method according to an exemplary embodiment of the present invention. In this exemplary embodiment of the present invention, the amplifying unit 130 for amplifying the received RF signal does not operate. However, even in the case in which the amplifying unit 130 operates, the method of setting the reference value according to the state signal can also be applied in the same manner as above.

As illustrated in FIG. 3, the control unit 140 decides whether the state signal has been output from the state decision unit 110 in operation S110.

If the state signal is output as a result of decision, the control unit 140 sets the reference value according to the output state signal in operation S120. In other words, the control unit 140 sets the second reference value according to the presently output state signal. The second reference value can also be set in consideration of information about the second reference value according to the output state signal.

Additionally, the second reference value set according to the state signal may be corrected using the average-level AGC signal stored in the signal storage unit 150. For example, if the average-level AGC signal is greater than the second reference value, the control unit may increase the set second reference value as much as a specified value; otherwise, it may decrease the second reference value as much as the specified value.

The control unit 140 compares the reference value (i.e., the second reference value) set according to the state signal with the pre-stored reference value (i.e., the first reference value) in operation S130. Specifically, the control unit 140 successively stores the set reference values in a buffer, and decides that the last stored reference value is the newest data. Accordingly, the control unit 140 compares the reference value set according to the output state signal with the last stored reference value.

If the set reference value is greater than the pre-stored reference value, the control unit 140 decides that the received RF signal is weak, and sets the amplifying unit 130 in an "on" state in operation S140.

Meanwhile, if the set reference value is less than the pre-stored reference, the control unit 140 decides that the received RF signal is strong, and sets the amplifying unit 130 in an "off" state. In this case, the received RF signal bypasses the amplifier S150.

As described above, the signal amplifying apparatus and method according to the present invention produces at least one of the following effects.

First, the RF signal can be efficiently amplified by changing the reference value with reference to the state of the RF signal according to the environment.

Second, the reference value can be set more accurately through management of the AGC signal according to the received RF signal.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A signal amplifying apparatus comprising:
a signal receiving unit (120) which is operable to output a state signal according to a state of a received radio frequency (RF) signal;
an amplifying unit (130) which is operable to amplify the received RF signal; and
a control unit (140) which is operable to determine whether to operate the amplifying unit (130) according to the state signal output by the signal receiving unit (120).

2. The signal amplifying apparatus as claimed in claim 1, wherein the state signal includes the signal-to-noise ratio of the received RF signal.

3. The signal amplifying apparatus as claimed in claim 2, wherein the control unit (140) is operable to set a reference value corresponding to the output state signal and to decide whether to operate the amplifying unit (130) by comparing the reference value which is set with a pre-stored reference value.

4. The signal amplifying apparatus as claimed in claim 3, wherein the control unit (140) is operable to decide to operate the amplifying unit (130) if the reference value which is set is greater than a pre-stored reference value and to decide to not operate the amplifying unit (130) if the reference value which is set is less than a pre-stored reference value

5. The signal amplifying apparatus as claimed in claim 3 or claim 4, further comprising:
an automatic gain control (AGC) unit (120) which is operable to output an AGC signal according to a strength of the received RF signal; and
a signal storage unit (150) which is operable to sample the AGC signal output by the AGC unit (120) at predetermined intervals and stores the AGC signal which is sampled.

6. The signal amplifying apparatus as claimed in claim 5, wherein the signal storage unit (120) is operable to store an average-level AGC signal according to a highest-level AGC signal and a lowest-level AGC signal.

7. The signal amplifying apparatus as claimed in claim 6, wherein the control unit (140) is operable to correct the reference value which is set according to a mean-level AGC signal.

8. A signal amplifying method comprising:
outputting a state signal according to a state of a received radio frequency (RF) signal; and
determining whether to amplify the received RF signal according to the state signal which is output.

9. The signal amplifying method as claimed in claim 8, wherein the state signal includes the signal-to-noise ratio of the received RF signal.

10. The signal amplifying method as claimed in claim 9, wherein the deciding whether to operate the amplifying unit (130) comprises:
setting a reference value corresponding to the state signal which is output; and
deciding whether to amplify the received RF signal by comparing the reference value which is set with a pre-stored reference value.

11. The signal amplifying method as claimed in claim 10, wherein it is decided to amplify the received RF signal if the reference value which is set is greater than a pre-stored reference value, and it is decided to not amplify the received RF signal if the reference value which is set is less than a pre-stored reference value

12. The signal amplifying method as claimed in claim 10 or claim 11, further comprising:
outputting an automatic gain control (AGC) signal according to a strength of the received RF signal; and
sampling the AGC signal which is output at predetermined intervals and storing the AGC signal which is sampled.

13. The signal amplifying method as claimed in claim 12, wherein the storing the AGC signal comprises storing a highest-level AGC signal and a lowest-level AGC signal and storing an average-level AGC signal according to the highest-level AGC signal and the lowest-level AGC signal which are stored.

14. The signal amplifying method as claimed in claim 13, further comprising correcting the reference value which is set according to a mean-level AGC signal.
